# EUROPEAN PATENT APPLICATION

(11) **EP 4 766 076 A1**
(43) Date of publication of application: **24.06.2026**
(21) Application number: 24221951.7
(22) Date of filing: 19.12.2024
(51) Int. Cl.: H10D 30/01, H10D 30/47

(54) **GALLIUM NITRIDE-SEMICONDUCTOR DEVICE WITH VERTICAL JFET AND LATERAL HEMT**

(71) Applicant: Imec VZW, 3001 Leuven (BE)
(72) Inventor: BORGA, Matteo, 3052 Oud-Heverlee (BE)
(74) Representative: EIP

(57) **Abstract**

A semiconductor device (100) for controlling a current flowing between a source terminal (102) and a drain terminal (104), as well as a method for forming such a device, is disclosed. The semiconductor device is formed from a layer stack of GaN layers, in which a vertical junction field-effect transistor, JFET, structure (120) and a lateral high electron mobility transistor, HEMT, structure (130) is provided to control the current.

## Description

### Technical field

The present disclosure relates to semiconductor devices, and specifically to GaN-based semiconductor devices comprising a junction field-effect transistor (JFET) and a high electron mobility transistor (HEMT).

### Background

Semiconductor devices based on GaN have gained increased attention in the field of power electronics due to their ability to operate at relatively high voltages and currents compared to traditional silicon-based devices. As a result, GaN-based transistors are increasingly used in applications such as power converters, inverters, and high-frequency switching systems.

Generally, a transistor's ability to achieve high voltage operation is largely attributed to the presence of a thick drift region, which is capable of withstanding high electric fields. However, such drift region is often associated with an increased gate-to-drain distance, resulting in a larger device footprint. This trade-off between high voltage capability and compactness poses a design challenge also for GaN-based transistors. Furthermore, as the gate-to-drain distance increases, challenges such as higher parasitic capacitance and reduced switching speeds may arise, negatively impacting the performance of the device in high-frequency applications.

Accordingly, there is a need for improved device designs that promotes high voltage handling capability while reducing device footprint, thereby enabling more efficient and compact GaN-based power devices.

### Summary

It is an objective of the present disclosure to provide a technology that addresses at least some of the above concerns. Further and alternative objectives may be understood from the following.

According to a first aspect, there is provided a semiconductor device configured to control a current path between a source terminal and a drain terminal. The semiconductor device comprises a layer stack arranged between the source terminal and the drain terminal, as well as a vertical junction field-effect transistor (JFET) structure and a lateral high electron mobility transistor (HEMT) structure formed in the layer stack. The layer stack comprises an n-type GaN drift layer arranged above, and electrically connected to the drain terminal, a p-type GaN first gate layer arranged above the drift layer, an unintentionally doped GaN channel layer arranged above the first gate layer, a barrier layer arranged above the channel layer, a p-type GaN second gate layer arranged above the barrier layer, and an n-type GaN channel region extending vertically through the channel layer and the first gate layer and being electrically connected to the drift layer. The JFET structure comprises a channel structure formed by the channel region and a gate structure formed by the first gate layer, wherein the channel structure is configured to form a current-conduction path between the drift layer and the channel layer. The HEMT structure comprises a channel structure formed at an interface between the channel layer and the barrier layer, and a gate structure formed by the gate layer, wherein the channel structure is configured to form a current-conduction path between the channel region and the source terminal. Furthermore, an interconnect structure is provided, which is configured to electrically connect the gate structure of the JFET structure to the source terminal.

According to a second aspect, there is provided a method for forming a semiconductor device according to the first aspect, comprising a vertical junction field-effect transistor, JFET, structure and a lateral high electron mobility transistor, HEMT, structure. The method comprises forming an opening in a layer stack comprising an n-type GaN drift layer, a p-type GaN first gate layer above the drift layer, an unintentionally doped GaN channel layer above the first gate layer, a barrier layer above the channel layer, and a second gate layer above the barrier layer. The opening extends at least through the channel layer and the first gate layer into the drift layer. The method further comprises forming, by epitaxial growth, a n-type GaN channel region in the opening. Further, a drain terminal is formed below the drift layer, and as well as a source terminal which is electrically connected to the first gate layer and the channel layer. The JFET structure comprises a channel structure formed by the channel region, and a gate structure formed by the first gate layer, wherein the channel structure is configured to form a current conduction path between the drift layer and the channel layer. The HEMT structure comprises a channel structure formed at an interface between the channel layer and the barrier layer, and a gate structure formed by the second gate layer, wherein the channel structure is configured to form a current-conduction path between the channel region and the source terminal.

According to a third aspect, a power conversion device is provided, comprising a semiconductor device according to the first aspect. Examples of such power conversion devices include converters (DC/DC, AC/DC, AC/AC), inverters, and motor drives.

The layer stack allows a JFET and a HEMT to be formed, which together may control the current flowing between the drain terminal and the source terminal of the semiconductor device. The drain of the JFET is electrically connected to the drain terminal of the semiconductor device, the source of the JFET is electrically connected to the drain of the HEMT, and the source of the HEMT is electrically connected to the source terminal of the semiconductor device. Additionally, the gate of the JFET is electrically connected to the source of the HEMT, which in turn is connected to the source terminal of the semiconductor device.

Advantageously, the JFET may be a normally-on device due to the behaviour of the pn-junction at its gate, whereas the HEMT may be a normally-off device owing to the p-type GaN second gate layer positioned above the barrier layer. This configuration allows the overall semiconductor device to be a normally-off device, remaining non-conducting for gate voltages below a threshold voltage of the HEMT. This allows the semiconductor device to meet the safety standards commonly required in power-conversion systems, aiming at preventing unintended current flow in case of a control signal failure.

The HEMT may be used to control the on/off state the semiconductor device. When the HEMT is turned off and the drain terminal potential of the semiconductor device increases, the potential of the common node, interconnecting the source of the JFET and the drain of the HEMT, may increase correspondingly. This increase may continue until the (negative) gate-to-source voltage of the JFET falls below its threshold voltage, at which point the JFET may turn off. This behaviour causes the voltage at the common node to become pinned to the inverse of the threshold voltage of the JFET as the drain terminal voltage continues to increase. Consequently, the maximum drain voltage that the HEMT must sustain to keep the overall semiconductor device in the non-conducting state may be limited to the inverse of the threshold voltage of the JFET. This design allows the HEMT to be relatively compact, as it is not required to sustain drain voltages exceeding the threshold voltage of the JFET, thereby reducing its contribution to the on-resistance of the semiconductor device.

In the on-state, the current may flow through the semiconductor device in series via the JFET and the HEMT. Specifically, the current may flow from the drain terminal, through the JFET channel, and further through the two-dimensional electron gas (2DEG) channel region formed at the heterojunction between the channel layer and the barrier layer of the HEMT, before finally reaching the source terminal.

The present configuration, in which the channel of the JFET is formed by the vertically extending n-type GaN channel region, and in which the HEMT is a lateral device formed at the interface between the channel layer and the barrier layer, allows the top surface of the layer stack to be shielded from the high potential at the drain terminal. Beneficially, this reduces the risk of adverse surface effects stemming from electric field crowding and accumulation of electrons within dielectric layers of the semiconductor device.

Furthermore, the vertical design of the JFET allows the drain terminal of the semiconductor device to be arranged at the backside of the layer stack, i.e., below the JFET and the HEMT. The voltage blocking capability, or breakdown voltage of the device, may thus scale with the thickness of the layer stack, and more specifically the thickness of the drift layer.

The monolithic integration of the JFET and HEMT in a shared GaN epitaxial layer stack may provide several advantages. By forming both transistors within the same layer stack, parasitic effects may be reduced, leading to improved high-frequency performance and reduced switching losses. The integration may also reduce the need for external interconnects between the JFET and the HEMT, providing a more compact device with a reduced footprint. Furthermore, the use of a single epitaxial layer stack may simplify the fabrication process, as the same growth and processing steps can be applied to both the JFET and the HEMT.

The JFET and the HEMT may comprise a complementary characteristic, with the JFET providing high-voltage blocking capability and the HEMT a precise and fast switching. Thus, the JFET may be referred to as a high-voltage device and the HEMT as a low-voltage device arranged in a cascode configuration. The JEFT may, for example, have a breakdown voltage of at least 600 V, such as in the range of 650 - 1200 V. As mentioned above, the breakdown voltage may be determined at least in part by the thickness of the drift layer. The drift layer may be a lightly doped layer configured to withstand high electric fields by distributing the voltage across its thickness. A thicker drift layer allows the depletion region to expand further, reducing the peak electric field at any given point. By increasing the thickness of the drift layer, the device may sustain a higher voltage before the electric field exceeds the material's critical electric field, causing avalanche breakdown.

The channel region, forming the vertical channel structure of the JFET, may be formed in an opening or aperture etched into the channel layer and the first gate layer of the layer stack. The channel region may be formed by n-type GaN epitaxial regrowth process. The conduction of this channel region may be modulated by the depletion of the pn-junction formed between the n-type GaN channel region and the p-type GaN first channel layer. The dimensions of the channel region, its doping, and the doping of the first channel layer may thus determine the threshold voltage of the JFET.

The layer stack may further comprise one or more heavily doped n-type GaN contact layer to facilitate low-resistance ohmic contact between adjacent layers. In some examples, such a heavily doped contact layer may be arranged between the drain terminal and the drift layer to reduce contact resistance between the drift layer and the drain terminal. In further examples, a heavily doped intermediate layer may be arranged between the first gate layer and the channel layer to reduce the depletion of the channel layer. In the context of the present disclosure, "heavily doped" typically refers to a semiconductor layer where the doping concentration is high enough (typically 10¹⁸ cm⁻³ or greater) to dominate the material's electrical behaviour.

The HEMT may comprise a p-type GaN gate, formed of a p-doped GaN layer above the barrier layer to create a depletion region that suppresses the 2DEG at zero gate voltage. This design allows the HEMT to be a normally-off device. Other gate designs are however possible, such as a metal-insulator-semiconductor (MIS) gate. The MIS gate may utilise a dielectric insulator layer (such as silicon nitride or aluminium oxide) between the gate metal and the barrier layer. The insulator layer may reduce gate leakage by providing electrical isolation. While a MIS gate may also enable normally-off operation, it often requires additional design elements, such as a recessed gate structure, to suppress the 2DEG at zero gate voltage.

The semiconductor device may further comprise a field plate structure arranged above the barrier layer and laterally between the gate layer and the channel region. The field plate structure may be employed to shape and control the electric field distribution within the semiconductor device. The field plate structure may comprise a metallic extension connected to the source terminal and may be placed over an insulating layer to modify the electric field in the device. More specifically, the field plate structure may be configured to reduce electric field crowding in the region between the channel region and the HEMT's gate by redistributing the electric field over a larger area. The field plate structure may be electrically connected to the source terminal and extend over the gate of the HEMT.

It should be noted that relative spatial terms such as "vertical", "upper", "above", "lower", "below", "stacked on top of" are to be understood as denoting locations or directions in relation to a normal direction of a substrate, or in relation to a bottom-up direction of the layer stack. Correspondingly, terms such as "lateral" and "horizontal" are to be understood as locations or directions parallel to the substrate, i.e., parallel to an upper surface or the main plane of extension of the substrate.

### Brief Description of Drawings

The above, as well as additional objects, features, and advantages, may be better understood through the following illustrative and non-limiting detailed description, with reference to the appended drawings. In the drawings, like reference numerals will be used for like elements unless stated otherwise.
FIG. 1A is a schematic cross section of a semiconductor device according to some examples.
FIG. 1B is a circuit diagram depicting the electrical connection of a JFET and a HEMT of a semiconductor device according to some examples.
FIGS. 2A-D are cross-sections of a semiconductor device according to some examples, schematically illustrating the depletion region of the JFET at different drain voltages.
FIGS. 3A-G are schematic cross sections illustrating various processing steps of a method for manufacturing a semiconductor device according to some examples.

### Detailed Description

Examples of a semiconductor devices comprising a JFET and a HEMT, as well as methods for forming such devices, will in the following be described with reference to the figures.

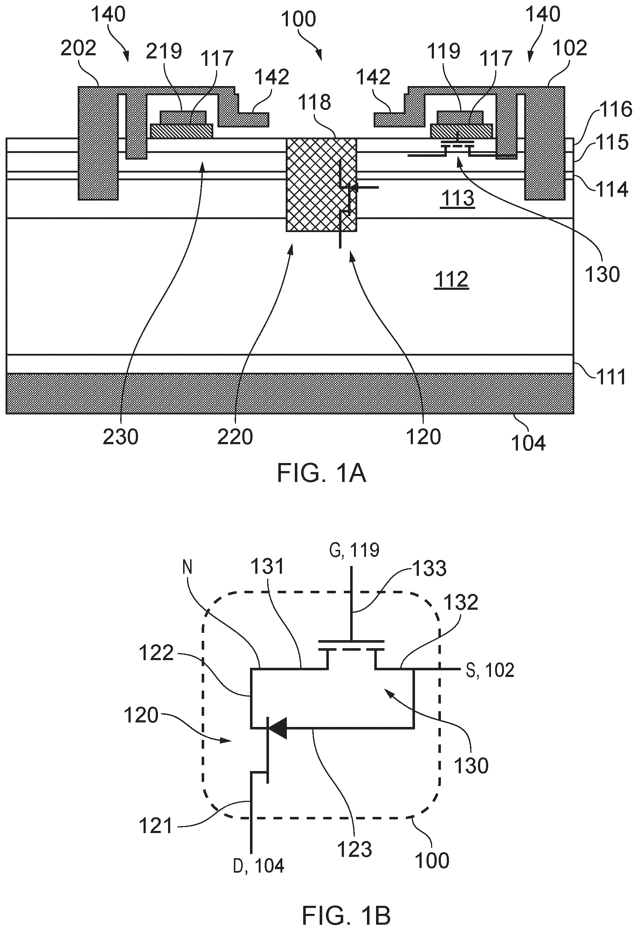

FIG. 1A shows a schematic cross section of a semiconductor device 100 according to an example. The semiconductor device 100 is formed from a layer stack arranged between a source terminal 102 and a drain terminal 104 of the semiconductor device 100. The layer stack comprises a plurality of epitaxially formed GaN layers - in the present example, from the bottom and up, an n-type drift layer 112 arranged above the drain terminal, a p-type first gate layer 113 arranged above the drift layer 112, an unintentionally doped channel layer 115 arranged above the first gate layer 113, a barrier layer 116 arranged above the channel layer 115, and a p-type second gate layer 117 arranged above the barrier layer 116. Optionally, one or more highly doped contact layers may be provided to reduce the electric resistance between adjacent layers. In the present example, a highly doped n-type contact layer 111 is arranged between the drain terminal 104 and the drift layer 112.

The layer stack further comprises an n-type GaN channel region 118 extending vertically through the channel layer 115 and the first gate layer 113 to contact the drift layer 112. The channel region 118 may be formed by epitaxial regrowth of n-type GaN in an opening formed in the layer stack. The dimensions of the channel region 118 may thus be determined by the dimensions of the opening, whereas the doping of the channel region 118 may be determined by the epitaxial growth process.

These different layers and regions of the layer stack provide junctions and regions that can be utilised to form a vertical JFET structure 120 and a lateral HEMT structure 130, indicated by circuit diagram symbols in FIG. 1A. The channel region 118, extending vertically from a top portion of the layer stack down to the drift layer 112, forms the channel region of the vertical JFET structure 120. The conductive state of the channel region may be modulated by the pn-junction depletion provided by the interface between the p-type first gate layer 113 and the n-type channel region 118, thereby allowing a current-conduction path between the drift layer 112 and the channel layer 115 to be controlled.

The channel structure of the HEMT structure 130 may be formed by a two-dimensional electron gas (2DEG) at a heterojunction between the channel layer 115 and the barrier layer 116. The heterojunction may be formed by the different bandgaps of the channel layer 115 and the barrier layer 116. The barrier layer 116 may, for example, be formed by AlGaN, acting as a barrier while the GaN of the channel layer 115 serves as the lateral channel region where conduction occurs. In other examples, the barrier layer 116 may be formed of InAlN, InGaN, AlN, or ScAlN.

The AlGaN and GaN layers may exhibit spontaneous and piezoelectric polarisation effects. At the heterojunction, the difference in polarisation between the two materials may create a fixed positive charge, which attracts free electrons from the surrounding material, forming a dense, confined layer of electrons. The electrons may be configured to a thin quantum well at the interface between the channel layer 115 and the barrier layer 116. This confinement may give rise to the 2DEG, where electrons may move laterally in two dimensions but are confined in the third. This allows for a HEMT structure 130 to be provided, forming a lateral current-conduction path between the source region of the JFET and the source terminal 102 via the channel layer 115.

Further, a heavily doped n-type intermediate layer 114 may be arranged between the first gate layer 113 and the channel layer 115 to prevent a possible depletion of the 2DEG from below.

An interconnect structure 140 may be provided to electrically connect the gate structure of the JFET structure 120, i.e., the first gate layer 113, as well as the source region of the HEMT, i.e., the channel layer 115, to the source terminal 102 of the semiconductor device 100. The interconnect structure 140 may comprise vertical interconnects, such as via connections, extending from a metallisation layer of the device down to the first gate layer 113 and the channel layer 115. As a result, the gate of the JFET structure 120 may be connected to the source of the HEMT structure 130.

A gate metal layer 119 may be formed on the gate layer 117 to form a gate structure of the HEMT structure 120. This gate structure may form the gate terminal of the overall semiconductor device 100.

In some examples, a field plate structure 142 may be provided to reduce field crowding in the semiconductor device 100. The field plate structure 142 may form part of the metallization layer and may extend from the vertical interconnects, contacting the first gate layer 113 and the channel layer 115 to the source terminal 102, and over the gate structure 119 to a location laterally between the gate structure 119 and the channel region 118.

FIG. 1A shows a symmetric layout, with a centrally located channel region 118 and a first HEMT structure 130 and a second HEMT structure 230 arranged on laterally opposite sides of the of the channel region 118. This configuration allows two JFET structures to be formed from the same channel region 118 - a first JFET structure 120 defining a current-conduction path from the drain terminal 104 to a first source terminal 102 via the first HEMT structure 130, and a second JFET structure 220 defining a current-conduction path from the drain terminal 104 to a second source terminal 202 via the second HEMT structure 230. Thus, it will be appreciated that each of these transistors may be formed from the same layer stack, i.e., from the same drift layer 112, first gate layer 113, vertical channel region 118, etcetera. Furthermore, the same metallisation layers may be employed to form the interconnect structures 140 of the respective transistors, as well as the respective gate structures 119, 219 of the first and second HEMT structures 130, 230.

In some examples, the gate structures 119, 219 of the first and second HEMT structures 130, 230 may be addressed independently, and in some examples, they may be electrically connected to each other and hence simultaneously addressable. The same applies to the first and second source terminals 102, 202 of the semiconductor device 100, which also may be addressed independently or interconnected to each other.

The semiconductor device 100 may be utilised in power conversion devices like converters and inverters. The dual-transistor arrangement of the semiconductor device 100 may provide the primary switching element of such power conversion devices, which may comprise a plurality of switching elements arranged in half-bridge configurations, full-bridge configurations, and other topologies enabling the voltage to be stepped up or down, or DC to be converted to AC.

It should be noted that the configuration in FIG. 1A is merely an illustrative example, and that other configurations also may be possible. The present disclosure is by no means limited to the symmetrical layout with a vertical channel region 118 arranged between two HEMT structures 130, 230. The semiconductor device 100 may as well comprise a single HEMT structure 230 and a single JFET structure 120, which preferably may comprise a vertical channel region 118 that is pinched by the first gate layer 113 from at least two sides so as to ensure efficient depletion of the channel region 118.

As indicated in FIG. 1A, the source of the resulting JFET 120 and the drain of the resulting HEMT 130 may be interconnected at a common node. An example of this layout is illustrated in FIG. 1B, which is a circuit diagram outlining the electrical relationship between the transistors and the terminals of the resulting semiconductor device 100.

FIG. 1B shows a type of cascode configuration, in which the JFET 120 and the HEMT 130 are connected in series to control a current path between the drain terminal D and the source terminal S of the semiconductor device 100. The drain of the JFET 120 is electrically connected to the drain terminal D, the source of the JFET 120 to the drain of the HEMT 130, and the source of the HEMT 130 to the source terminal S. The gate of the HEMT 130 forms the gate terminal G of the resulting semiconductor device 100. Further, the gate of the JFET 120 is electrically connected to the source of the HEMT 130.

The JFET 120 may be referred to as a high-voltage transistor configured to block high voltages, such as 600 V and above, when the semiconductor device 100 is arranged in a blocking state, or off-state. The HEMT 130, on the other hand, may be referred to as a low-voltage transistor configured to open and close the current path. The JFET 120 may be a normally-on device, i.e., conducting current at gate zero gate voltage or gate voltages below the threshold voltage, whereas the HEMT 130 may be a normally-off device requiring an applied gate voltage to conduct current.

The source of the JFET 120 and the drain of the HEMT 130 are interconnected at the common node N. This configuration of the transistors 120, 130 allows the voltage V_{N} at the common node N to be pinned to the inverse of the threshold voltage Vt_{JFET} of the JFET 120 (note that the threshold voltage in this configuration is negative). As a result, the maximum voltage V_{N}, i.e., the maximum drain voltage that the HEMT 130 must sustain to keep the overall semiconductor device 100 in the non-conducting state may be limited to the inverse of the negative threshold voltage Vt_{JFET} of the JFET 120. Advantageously, the common node N is an internal node, fully integrated in the layer stack and does not require any interconnections or metallisations.

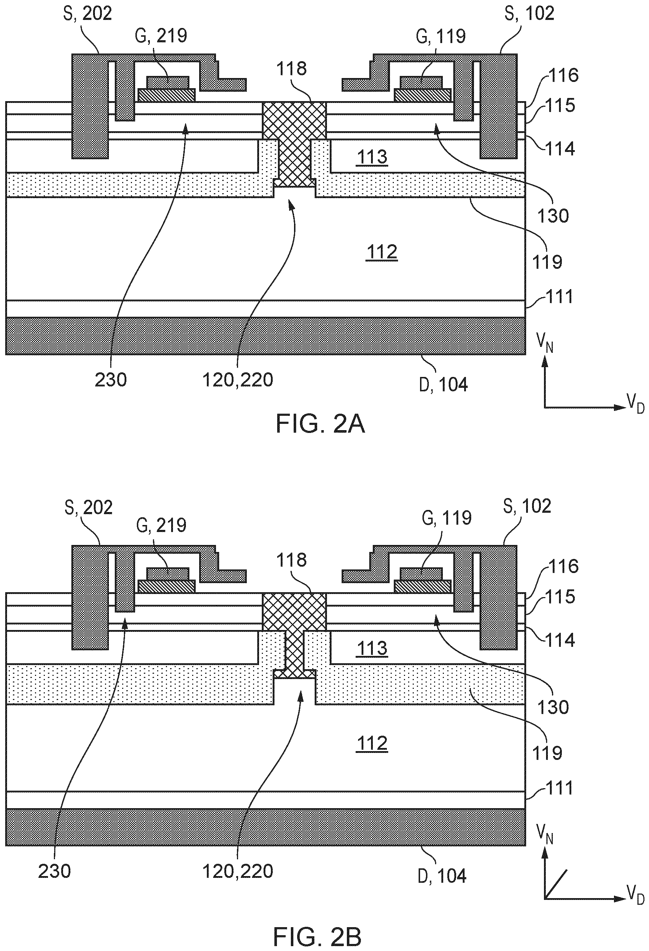

FIGS. 2A-D illustrate schematically the off-state operation of a semiconductor device 100, which may be configured similarly to the semiconductor device in FIG. 1A. The figures illustrate the semiconductor device 100 when the first and second HEMTs 130, 230 are in a non-conducting state, resulting from a gate voltage V_{G} below the threshold voltage, such as a zero gate voltage, being applied to the respective gate terminals G of the semiconductor device 100.

FIGS. 2A-D are a sequence of figures showing the extension of a depletion region 119 of the JFET 120 in response to an increasing drain voltage V_{D} being applied to the drain terminal D of the semiconductor device 100. To the left in each figure, a cross section of the deivce 100 is shown, indicating the depletion region 119. To the right, a graph is shown, illustrating the voltage V_{N} of the common node N as a function of the drain voltage V_{D}.

FIG. 2A shows the depletion region 119 when the drain voltage V_{D} and, thus, the voltage V_{N} at the common node N are zero. In this state, the JFET 120 is in a conducting state and the HEMT 130 is in a non-conducting state. Accordingly, the depletion region 119 at the interface between the drift layer 112 and the first gate layer 113 is relatively small and not extending completely through the channel region 118.

In FIG. 2B, the drain voltage V_{D} has been increased, but is still below the inverse of the threshold voltage Vt_{JFET}. The depletion region 119 is larger, but does not extend throughout the channel region 118. The JFET is therefore in the conducting state. In this operating regime, the drain of the HEMT 130 is exposed to a common node voltage V_{N} that follows the increasing drain voltage V_{D}, as shown in the diagram.

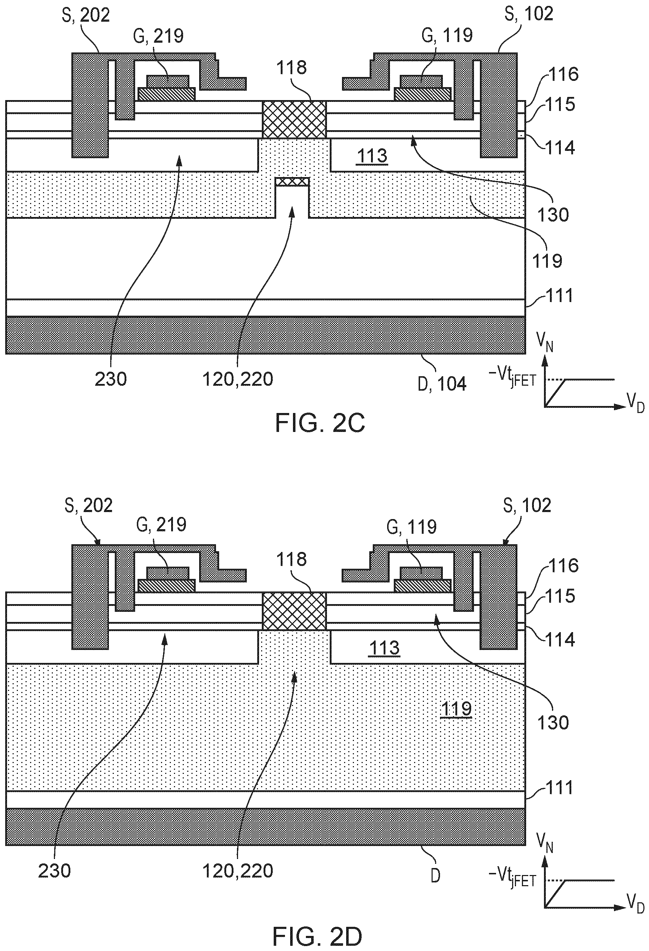

In FIG. 2C, the drain voltage V_{D} exceeds the inverse of the threshold voltage Vt_{JFET} of the JFET 120, causing the depletion region 119 to deplete the vertical channel region 118 from two sides. As a result, the channel of the JFET 120 enters a non-conducting state, blocking the current path and pinning the voltage V_{N} of the common node N to the inverse of the threshold voltage Vt_{JFET} of the JFET 120, as illustrated in the diagram. A major part of the increasing drain voltage V_{D} may now be carried by the JFET 120 and the increasing depletion region 119, whereas the HEMT 130 remains exposed to the substantially constant voltage V_{N} at the common node N.

FIG. 2D shows the semiconductor device 100 with a fully depleted drift layer 112, with the depletion region 119 spanning the entire thickness of the drift layer 112. The common node voltage V_{N}, however, may be substantially constant at -Vt_{JFET} throughout this phase.

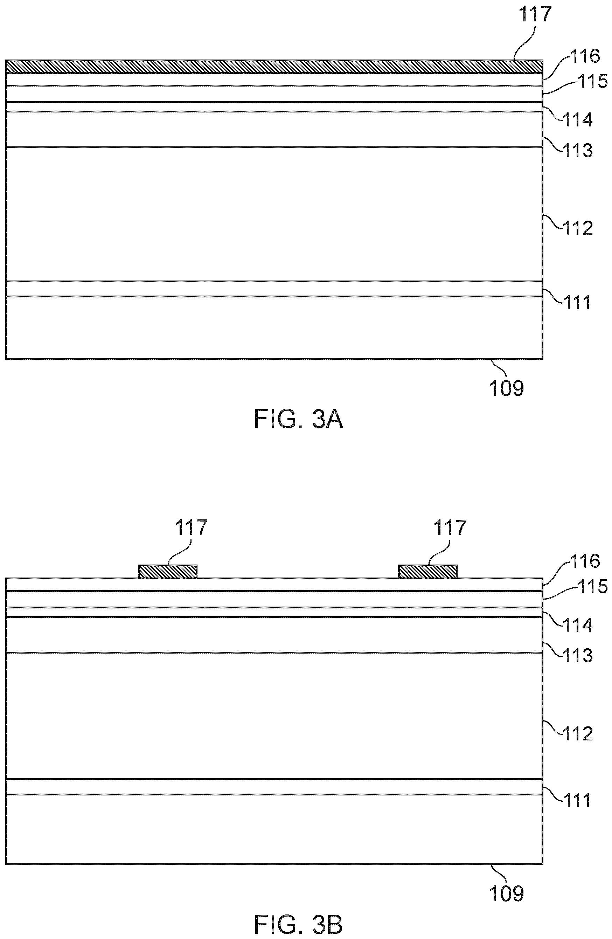

An example method for forming a semiconductor device 100 as shown in any of the above figures will now be discussed with reference to the cross-sectional views in FIGS. 3A-G, illustrating various stages of the fabrication. It should be noted that the proposed method is an illustrating example and that other methods are possible as well, depending on the particular configuration and performance requirements of the semiconductor device 100.

FIG. 3A shows a cross section of an example layer stack, arranged on a substrate 109. The layer stack may typically be grown on a substrate 109 using metal-organic chemical vapour deposition (MOCVD), hydride vapour phase epitaxy (HVPE), or molecular beam epitaxy (MBE) techniques. The substrate 109 provides mechanical support and may serve as a foundation for the epitaxial growth of the different GaN layers. Examples of substrates 109 include silicon, silicon carbide, GaN, polycrystalline AlN, and sapphire substrates.

The layer stack may be grown sequentially, with each layer provided with a doping profile and a thickness forming the functional regions of the resulting JFET and HEMT. The layer stack may comprise a highly n-doped GaN contact layer 111, which may be grown directly on the substrate 109 as the first layer of the stack. This layer 111 may serve multiple purposes, such as providing a low-resistance interface for electrical connections and acting as a foundation for the subsequent epitaxial growth of the drift layer. The contact layer 111 may typically have a doping concentration in the order of 10¹⁸-10¹⁹ cm⁻³.

The n-doped GaN drift layer 112 may be grown on the contact layer 111. The thickness and doping concentration of the drift layer 111 may be designed to balance high breakdown voltage and low on-resistance of the resulting JFET. The thickness may typically range from 7-15 µm for power transistors with breakdown voltages in the range of 600-1200 V. The doping concentration may in some examples be in the range of 10¹⁵-10¹⁶ cm⁻³.

The layer stack may further comprise a first gate layer 113, which may be a p-doped GaN layer forming the gate region of the JFET. The first gate layer 113 may be doped with acceptor impurities, typically magnesium, to introduce holes as the majority carriers. Doping level may be selected to balance the conductivity and device stability and may typically range between 10¹⁷ and 10²⁰ cm⁻³.

Optionally, the layer stack may comprise an intermediate layer 114 formed on the first gate layer 113. The intermediate layer 114 may be a heavily doped n-type GaN layer configured to prevent the 2DEG to deplete from below and allow the conductive state to be controlled by the depletion induced locally by the second gate layer 117. The intermediate layer 114 may comprise a doping concentration of 10¹⁸ cm⁻³ or greater.

The layer stack may further comprise an unintentionally doped GaN channel layer 115 arranged above the first gate layer 113. The unintentionally doped channel layer 115 may be grown on the intermediate layer 114 and may be configured to form a current-conduction path for the HEMT. The channel layer 115 may be formed without the intentional addition of doping elements. However, due to inherent impurities or defects during the growth process, it may in some examples exhibit a light n-type conductivity, allowing 2DEG formation without introducing excessive electron scattering. The channel layer 115 may typically be around 100-500 nm thick.

A barrier layer 116 may be formed on the channel layer 115. The barrier layer 116 may be formed of a wide-bandgap material like AlGaN and is configured to form a heterojunction giving rise to the 2DEG. The barrier layer 116 may be relatively thin, such as in the range of 10-30 nm.

The gate of the HEMT 130 may be formed by a p-type GaN second gate layer 117. The first gate layer 113 may help deplete the 2DEG of the HEMT to prevent the HEMT from conducting under zero gate bias. The inclusion of a p-GaN gate may locally suppress the 2DEG at zero gate voltage, thereby providing a normally-off operation of the HEMT 130. The thickness and doping concentration of the second gate layer 117 may be selected to determine the threshold voltage V_{tHEMT} of the HEMT 130, which in some examples may be in the range 1-3 V. The second gate layer 117 may about 100 nanometres thick and doped with Mg. The doping concentration may typically range from 10¹⁸-10²⁰ cm⁻³.

The example method shown in FIGS. 3A-G may be used to form a semiconductor device 100 similar to the devices shown in FIGS. 1A and 2A-D. Hence, the example device 100 may comprise a symmetric configuration, with a HEMT arranged on both sides of a central JFET structure. It should be noted that the appended claims by no means are limited to such a configuration. Other configurations, including a single JFET and a single HEMT as indicated in FIG. 1B, are also possible.

FIG. 3B shows the layer stack after the second gate layer 117 has been patterned to form the gate regions of the first and second HEMTs.

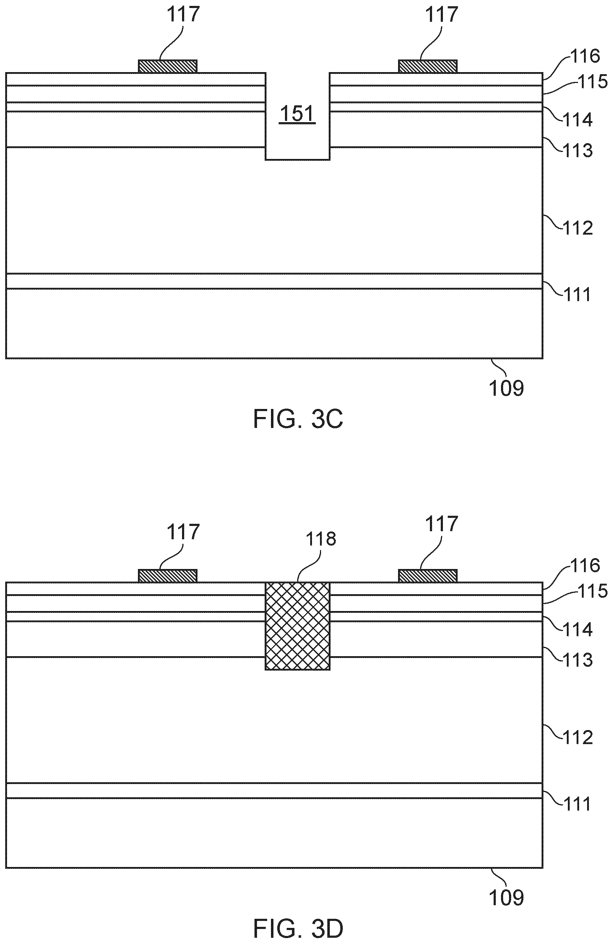

An opening, or aperture 151 may be formed between the gate regions, as shown in FIG. 3C. The opening 151 may be etched into the layer stack, through the barrier layer 116, the channel layer 115, the intermediate layer 114 (if any), and the first gate layer 113, all the way down to the drift layer 112.

Thereafter, the opening 151 may be regrown with an n-type GaN material, forming the vertical channel region 118 providing the channel of the resulting JFETs. By etching the opening 151 at least until the drift layer 112 is exposed, the channel region 118 is allowed to be electrically connected to the drift layer 112. The channel region 118 may be selectively grown in the opening, or by means of a blanket regrowth. In case of the latter, a removal step will follow to remove excess n-type GaN. The resulting structure is shown in FIG. 3D.

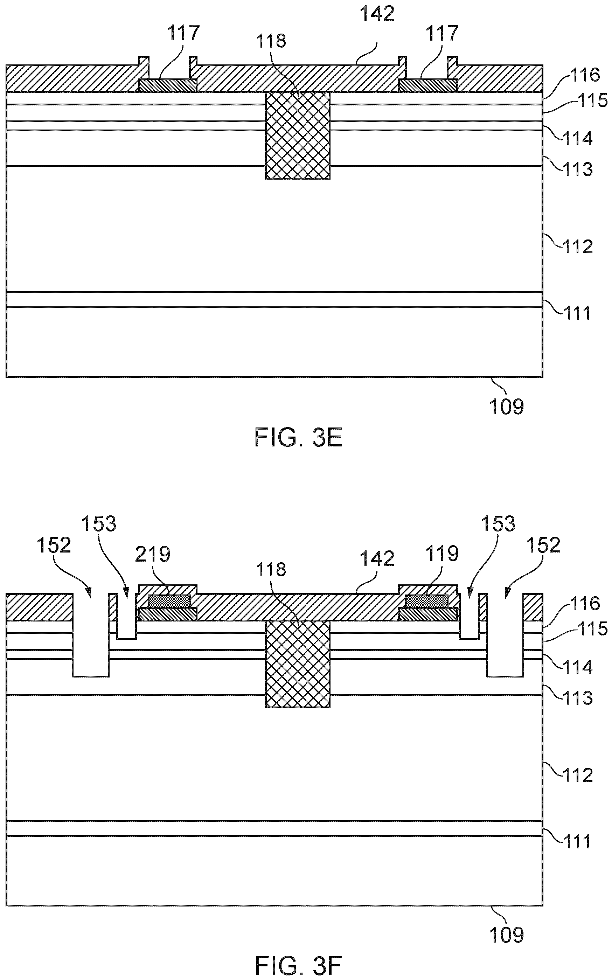

In FIG. 3E, a passivation layer 142 has been formed above the layer stack. The passivation layer 142 has further been patterned to form openings at the gate layer 117, defining the gate metal of the HEMTs.

In FIG. 3F, the gate metal 119, 219 has been formed to allow the conductive state of the respective HEMTs (and hence the resulting semiconductor device) to be controlled. Further, trenches or contact openings 152, 153 have been opened for the contacts to the first gate layer 113 and the channel layer 115. The trenches 152, 153 are located such that the gate structures of the respective HEMTs, formed by the gate layer 113 and the gate metal 119, 219, are arranged between the trenches 152, 153.

These trenches 152, 153 may be formed in sequence, in which the deeper ones of the trenches 152, exposing the first gate layer 113, may be formed first, followed by the shallower ones 153, exposing the channel layer 115. The trenches 152, 153 may be filled with a metal to form vertical interconnects and allow the gate layer 113 and the channel layer 115 to be electrically accessed from above.

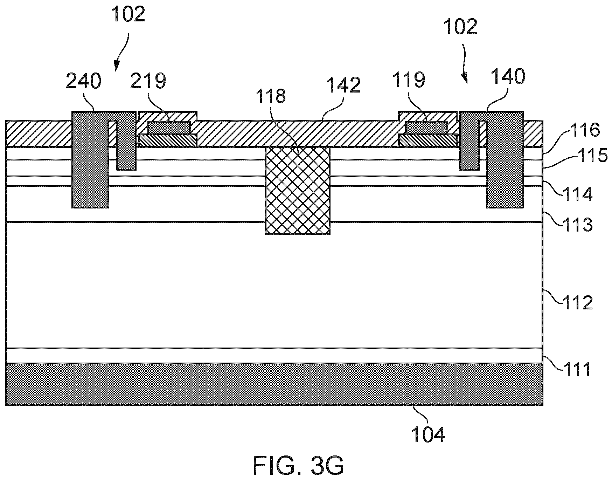

The resulting device is shown in FIG. 3G, with the first interconnect structure 140 formed at the first HEMT, the second interconnect structure 240 formed at the second HEMT, and a drain terminal 104 contacting the drift layer 112 from below. During operation, a current may flow from the drain terminal 104, through the drift layer 112, and the JFET channel formed by the channel region 118, and further laterally through the 2DEG in the channel layer 115 to the source terminal formed at the interconnect structures 140, 240.

### Concluding remarks

In the above, the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A semiconductor device (100) configured to control a current flowing between a source terminal (102) and a drain terminal (104), comprising:
a layer stack arranged between the source terminal and the drain terminal, the layer stack comprising:
an n-type GaN drift layer (112) arranged above, and electrically connected to, the drain terminal,
a p-type GaN first gate layer (113) arranged above the drift layer,
an unintentionally doped GaN channel layer (115) arranged above the first gate layer,
a barrier layer (116) arranged above the channel layer,
a p-type GaN second gate layer (117) arranged above the barrier layer,
an n-type GaN channel region (118) extending vertically through the channel layer and the first gate layer and being electrically connected to the drift layer;
the semiconductor device further comprising:
a vertical junction field-effect transistor, JFET, structure (120) comprising a channel structure formed by the channel region (118) and a gate structure formed by the first gate layer (113), wherein the channel structure is configured to form a current-conduction path between the drift layer and the channel layer (115);
a lateral high electron mobility transistor, HEMT, structure (130) comprising a channel structure formed at the heterojunction between the channel layer (115) and the barrier layer (116), and a gate structure formed by the gate layer (117), wherein the channel structure is configured to form a current-conduction path between the channel region (118) and the source terminal; and
an interconnect structure (140) electrically connecting the gate structure of the JFET structure to the source terminal.

2. The semiconductor device according to claim 1, wherein the JFET structure has a breakdown voltage of at least 600 V.

3. The semiconductor device according to claim 1 or 2, wherein the channel region is formed in an opening etched into the channel layer and the first gate layer.

4. The semiconductor device according to any of the preceding claims, further comprising a heavily doped n-type GaN contact layer (111) arranged between the drain terminal and the drift layer.

5. The semiconductor device according to any of the preceding claims, further comprising a heavily doped n-type GaN intermediate layer (114) arranged between the first gate layer and the channel layer.

6. The semiconductor device according to any of the preceding claims, wherein the gate layer is a p-type GaN layer.

7. The semiconductor device according to any of the preceding claims, wherein the barrier layer is formed of AlGaN.

8. The semiconductor device according to any of the preceding claims, further comprising a field plate structure (142) arranged above the barrier layer and laterally between the gate layer and the channel region.

9. A method for forming a semiconductor device (100) comprising a vertical junction field-effect transistor, JFET, structure (120) and a lateral high electron mobility transistor, HEMT, structure (130), comprising:
providing a layer stack comprising an n-type GaN drift layer (112), a p-type GaN first gate layer (113) above the drift layer, an unintentionally doped GaN channel layer (115) above the first gate layer, a barrier layer (116) above the channel layer, and a second gate layer (117) arranged above the barrier layer;
forming, in the layer stack, an opening (151) extending through the channel layer and the first gate layer into the drift layer;
forming, by epitaxial growth, a n-type GaN channel region (118) in the opening;
forming a drain terminal (104) below the drift layer; and
forming a source terminal (102) electrically connected to the first gate layer and the channel layer;
wherein the JFET structure comprises a channel structure formed by the channel region, and a gate structure formed by the first gate layer, the channel structure being configured to form a current conduction path between the drift layer and the channel layer; and
wherein the HEMT structure comprises a channel structure formed at an interface between the channel layer and the barrier layer, and a gate structure formed by the gate layer, the channel structure being configured to form a current-conduction path between the channel region and the source terminal.

10. The method according to claim 9, wherein the gate layer is a p-type GaN layer.

11. The method according to claim 9 or 10, wherein the barrier layer is an AlGaN layer.

12. The method according to any of claims 9-11, further comprising forming a heavily doped n-type GaN contact layer (111) on the drift layer.

13. The method according to any of claims 9-12, further comprising forming a heavily doped n-type GaN intermediate layer (114) on the channel layer.

14. The method according to any of claims 9-13, wherein the layer stack is epitaxially grown on a Si substrate or a SiC substrate.

15. An electrical power conversion device, comprising a semiconductor device according to any of claims 1-8.
